Europäisches Patentamt

European Patent Office

Office européen des brevets

(11) Numéro de publication: **0 170 777**
**A1**

# DEMANDE DE BREVET EUROPEEN

(21) Numéro de dépôt: **85104032.9**

(22) Date de dépôt: **04.04.85**

(51) Int. Cl.⁴: **G 11 C 11/24**

(30) Priorité: **06.04.84  FR 8405480**

(43) Date de publication de la demande: **12.02.86**
**Bulletin 86/7**

(84) Etats contractants désignés: **DE FR GB NL SE**

(71) Demandeur: **THOMSON-CSF TELEPHONE,**
**146, Boulevard de Valmy, F-92707 Colombes (FR)**

(72) Inventeur: **Charransol, Pierre, 6, rue de Toul,**
**F-75012 Paris (FR)**
Inventeur: **Audrix, Jean-Claude, 9, avenue Nicolas Gillet,**
**F-92700 Colombes (FR)**
Inventeur: **Goult, Jacques, 52, rue Ménilmontant,**
**F-75020 Paris (FR)**

(74) Mandataire: **Weinmiller, Jürgen et al, Zeppelinstrasse 63,**
**D-8000 München 80 (DE)**

(54) **Cellule élémentaire de mémoire vive, et mémoire vive réalisée par association de telles cellules élémentaires.**

(57)  Cette cellule élémentaire de mémoire vive comporte un premier interrupteur (1) dont l'une des entrées constitue l'entrée-sortie de données de la cellule, et dont l'autre entrée est reliée à une boucle comportant dans l'ordre un premier inverseur (4), un deuxième inverseur (5) et un deuxième interrupteur (6), le premier et le deuxième interrupteurs étant commandés de manière que lors d'une opération d'écriture, le premier soit fermé et le deuxième ouvert, qu'en dehors de toute opération d'écriture ou de lecture, le premier soit ouvert et le deuxième fermé, et que lors d'une opération de lecture, le premier et le deuxième soient fermés.

Une mémoire vive à N mots de P éléments binaires est obtenue par association de N × P cellules élémentaires de ce type suivant une matrice à N lignes et P colonnes.

Application à la réalisation de mémoires vives en circuits intégrés.

## CELLULE ELEMENTAIRE DE MEMOIRE VIVE, ET MEMOIRE VIVE REALISEE PAR ASSOCIATION DE TELLES CELLULES ELEMENTAIRES

La présente invention concerne une cellule élémentaire de mémoire vive, et une mémoire vive obtenue par association de telles cellules élémentaires, plus particulièrement réalisées en circuit intégré, notamment en circuit intégré du type prédiffusé.

On entend par circuit intégré prédiffusé un ensemble de transistors, par exemple de type MOS, qui sont confectionnés à l'avance sur un même substrat semi-conducteur, suivant une structure régulière et indépendante de la fonction devant être réalisée ultérieurement par ce circuit intégré, et qui sont ensuite interconnectés à la demande, suivant le type de fonction à réaliser par ce circuit intégré, un certrain nombre de zones réservées aux interconnexions étant pour cela prévu à la surface du circuit intégré.

Cette technique a pour avantage de concentrer sur la phase ultime du procédé de fabrication la réalisation de la partie "personnalisée" du circuit intégré, à savoir les interconnexions, et de reporter sur les phases précédentes la réalisation de la partie "standard" du circuit intégré, commune à l'ensemble des utilisateurs.

Elle a en revanche pour inconvénient, à partir d'un certain degré de complexité de la fonction à réaliser, de rendre très complexe la réalisation des interconnexions. En effet, les transistors étant disposés suivant des rangées parallèles, les interconnexions représentent un réseau essentiellement disposé entre ces rangées (il y a en fait un certain nombre d'interconnexions dans les rangées elles-mêmes).

Or on imagine aisément que les cas de figure sont extrêmement nombreux suivant l'architecture et le type de fonction à réaliser, ce qui cadre mal avec l'extrême rigidité de la structure décrite.

Un résultat bien connu d'une telle contradiction entre richesse d'un circuit en interconnexions et surface affectée à ces interconnexions (surface non modifiable) est que les constructeurs de circuits intégrés recommandent de laisser inutilisés un certain nombre de transistors (20% dans les cas relativement simples) pour faciliter l'opération de passage des interconnexions. Suivant la complexité relative des fonctions à réaliser, on constate donc dans certains cas une perte de rendement des circuits en surface utilisée, ou à l'opposé des difficultés de réaliser le graphe d'interconnexion (lorsque le réseau d'interconnexion est très dense) et une perte de temps importante pour le réaliser. Dans certains cas la difficulté peut être telle que les constructeurs de circuits intégrés sont amenés à modifier la partie "standard" du circuit pour accorder une plus large place aux zones réservées aux interconnexions, ce qui se traduit bien sûr par une perte de rendement pour tous les utilisateurs, c'est-à-dire quelle que soit la fonction à réaliser.

La demande de brevet français déposée le 26 Mars 1982 au nom de la demanderesse sous le numéro d'enregistrement national 82 05245 fournit une solution à ce problème, qui consiste à faire se succéder de manière continue des rangées de transistors sur toute la surface du substrat, et à utiliser, lorsque c'est nécessaire, la surface occupée par certaines de ces rangées, alors non alimentées, pour effectuer des interconnexions horizontales (les rangées de transistors étant supposées horizontales). Pour disposer d'un réseau complet d'interconnexions, des interconnexions verticales peuvent ensuite être effectuées sur une couche isolante recouvrant les interconnexions horizontales.

Cette dernière technique correspond à la technique dite des circuits intégrés prédiffusés à interconnexions libres.

La présente invention concerne plus particulièrement la réalisation de mémoires vives (encore appelées mémoires à accès aléatoire) en circuits intégrés. Il ne s'agit pas ici de mémoires de parties centrales (pour lesquelles les boîtiers mémoires du marché à capacité élevée sont certainement la meilleure solution) mais de mémoires décentralisées pour tâches spécifiques de traitement périphérique. Dans ce cas l'utilisation des mémoires standard du marché offre un rendement très faible car leur gamme n'est pas infinie, et leur format n x p (n mots de p bits) n'est pas adaptable à des cas particuliers sans une perte coûteuse des mots ou des bits non utilisés.

La présente invention a pour objet une cellule élémentaire de mémoire vive, ainsi qu'un arrangement de telles cellules élémentaires pour former une mémoire vive de format n x p (n mots de p bits) particulièrement adaptés à une réalisation en circuit intégré MOS du type prédiffusé à interconnexions libres.

L'invention permet en effet de limiter le réseau d'interconnexions d'une mémoire vive réalisée en circuit intégré prédiffusé à interconnexions libres aux interconnexions verticales, et donc de considérer comme active, et électriquement alimentée, l'ensemble de la surface de ce circuit intégré. De plus la réalisation d'une cellule élémentaire de mémoire vive suivant l'invention ne nécessite que huit transistors (quatre de type P, quatre de type N), ce qui, compte tenu de l'organisation des transistors dans un circuit intégré du type prédiffusé à interconnexions libres, assure un faible encombrement, associé à une grande campacité.

Par ailleurs, le fait que chaque cellule élémentaire suivant l'invention ne nécessite, aussi bien en écriture, qu'en lecture, ou qu'en l'absence de toute opération d'écriture ou de lecture, que deux signaux de commande, autorise un adressage matriciel et, partant, une disposition matricielle d'un ensemble de telles cellules pour former une mémoire de format n x p (n mots de p bits), ce qui offre une possiblité d'extension de cette mémoire par simples répétitions, sans modification profonde de structure et donc du procédé de fabrication.

La cellule élémentaire de mémoire vive suivant l'invention comporte un premier interrupteur dont l'une des entrées constitue l'entrée-sortie de données de la cellule, et dont l'autre entrée est reliée à une boucle comportant dans l'ordre un premier inverseur, un deuxième inverseur et un deuxième interrupteur, le premier et le

4

deuxième interrupteur étant commandés de manière que lors d'une opération d'écriture, le premier soit fermé et le deuxième ouvert, qu'en dehors de toute opération d'écriture ou de lecture, le premier soit ouvert et le deuxième fermé, et que lors d'une opération de lecture, le premier et le deuxième soient fermés.

Les objets et caractéristiques de la présente invention apparaîtront plus clairement à la lecture de la description suivante d'un exemple de réalisation, faite en relation avec les dessins ci-annexés dans lesquels :

- la figure 1 est un schéma logique d'une cellule élémentaire de mémoire vive suivant l'invention.

- les figures 2a et 2b montrent respectivement la réalisation, à l'aide de transistors MOS, d'un interrupteur et d'un inverseur formant la cellule élémentaire de mémoire représentée sur la figure 1.

- les figures 3a, 3b, 3c sont respectivement des schémas illustrant le fonctionnement de la cellule élémentaire représentée sur la figure 1, respectivement au cours d'une opération d'écriture, en l'absence de toute opération d'écriture ou de lecture, et au cours d'une opération de lecture.

- la figure 4 est un schéma d'implantation d'un circuit intégré réalisant une cellule élémentaire de mémoire vive suivant l'invention.

- la figure 5 est un schéma montrant la réalisation d'une mémoire vive de format n x p (à tire d'exemple 4 mots de 2 éléments binaires) à partir de cellules élémentaires suivant l'invention.

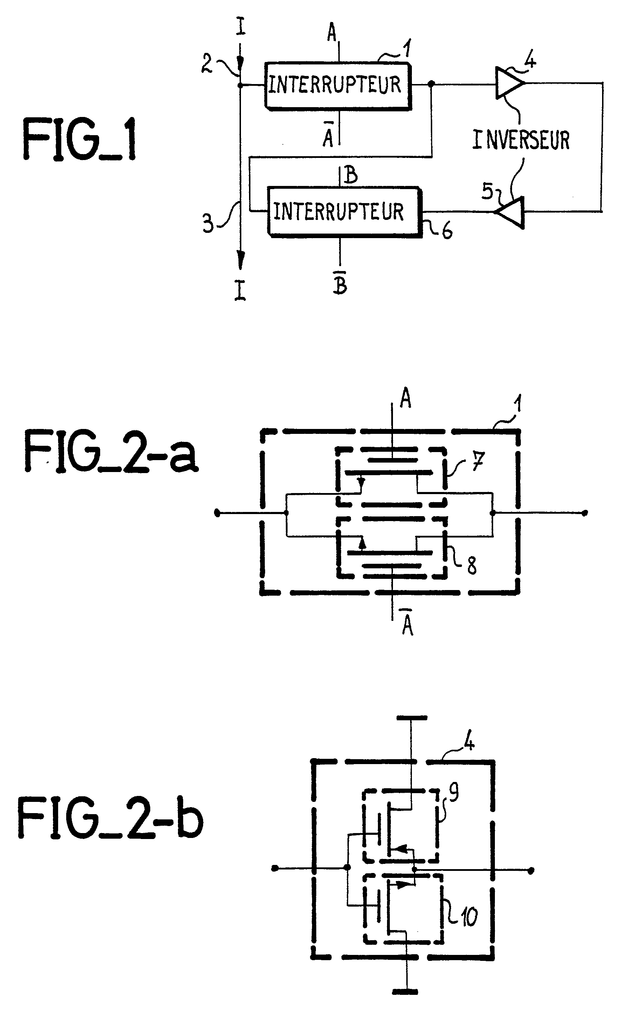

La cellule élémentaire de mémoire vive représentée sur la figure 1 comporte un premier interrupteur 1 qui est connecté d'une part à un fil d'écriture 2 véhiculant les informations I à écrire dans cette cellule et à un fil de lecture 3 véhiculant les informations I lues dans cette cellule, d'autre part à une boucle comportant dans l'ordre un premier inverseur 4, un second inverseur 5 et un second interrupteur 6.

On a représenté sur la figure 2a la réalisation d'un interrupteur, à titre d'exemple l'interrupteur 1, à l'aide de transistors MOS.

Cet interrupteur est formé par l'association en parallèle de deux transistors, l'un, 7, de type N, l'autre, 8, de type P, dont le drain et la source (ou électrodes de transfert) sont respectivement reliés et dont la grille (ou électrode de commande) reçoit soit un signal de commande A soit son complément Ā suivant le type (N ou P) de transistor. L'interrupteur 6 est réalisé de la même façon, les signaux de commande étant alors désignés par B et B̄.

Le fait que deux signaux de commande de complémentaires soient appliquées respectivement sur la grille de deux transistors MOS de types opposés ainsi associés implique que ces deux transistors soient simultanément dans le même état : passant ou bloqué. S'ils sont tous les deux passants, le niveau logique appliqué à l'une quelconque des électrodes de transfert se retrouve donc sur l'autre, et inversement, s'ils sont tous les deux bloqués, le niveau logique appliqué à l'une quelconque des électrodes de transfert ne se retrouve pas sur l'autre. Il s'agit donc bien d'un interrupteur.

On a représenté sur la figure 2b la réalisation d'un inverseur, à titre d'exemple l'inverseur 4, (l'inverseur 5 étant réalisé de la même façon) à l'aide de transistors MOS. Cet inverseur est formé par l'association en série de deux transistors, l'un, 9, de type N, l'autre, 10, de type P, reliés par l'une de leurs électrodes de transfert, l'autre électrode de transfert étant mise à un potentiel déterminé. Un même signal d'entrée est appliqué à l'électrode de commande de ces deux transistors et le signal de sortie correspondant est obtenu sur l'électrode de transfert commune à ces deux transistors.

Le fait qu'un même signal de commande soit appliqué simultanément sur la grille de deux transistors de type opposés ainsi associés implique qu'ils soient simultanément dans deux états opposés, l'un passant, l'autre bloqué, et dans chacun des cas, le montage particulier de celui des deux qui est passant implique qu'il se comporte comme un inverseur.

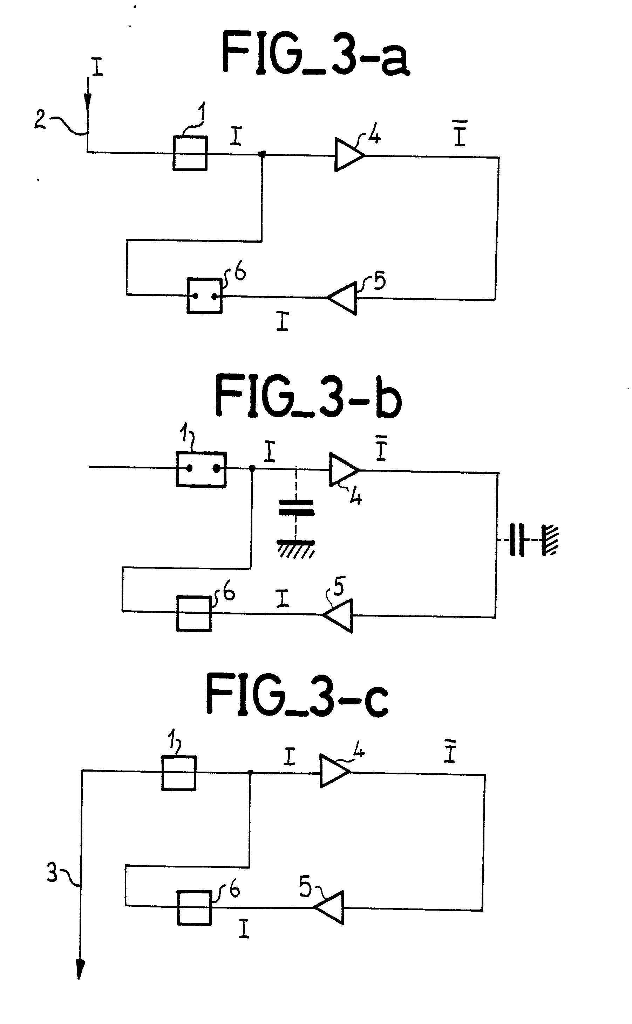

On se reporte maintenant à la figure 3 illustrant le fonctionnement de la cellule élémentaire représentée sur la figure 1.

Au cours d'une opération d'écriture, les signaux de commande A, $\bar{A}$, B, $\bar{B}$ des interrupteurs 1 et 6 sont tels que l'interrupteur 1 est fermé et l'interrupteur 6 ouvert. Le schéma de la cellule élémentaire est alors équivalent à celui représenté sur la figure 3a, où l'interrupteur 1 a été symbolisé par un trait continu et l'interrupteur 6 par un trait interrompu. L'information I à écrire, présente sur le fil 2, se retrouve alors inversée ($\bar{I}_e$) en sortie de l'inverseur 4, puis à nouveau inversée (I) en sortie de l'inverseur 5.

En l'absence de toute opération d'écriture ou de lecture, les signaux de commande A $\bar{A}$, B, $\bar{B}$ des interrupteurs 1 et 6 sont tels que l'interrupteur 1 est ouvert et l'interrupteur 6 fermé. Le schéma de la cellule élémentaire est alors équivalent à celui représenté sur la figure 3b. Le passage en transitoire de la situation de la figure 3a (où une information à écrire I est disponible en sortie de l'interrupteur 1) à la situation de la figure 3b (où l'information I n'est plus disponible en sortie de l'interrupteur 1) ne détruit pas l'information I en raison de l'influence prépondérante des capacités parasites figurées sur le schéma. La boucle formée par les inverseurs 4 et 5 assure alors la permanence statique de l'information I dans la cellule mémoire élémentaire.

Au cours d'une opération de lecture, les signaux de commande A, $\bar{A}$, B, $\bar{B}$ des interrupteurs 1 et 6 sont tels que ces deux interrupteurs sont simultanéments fermés. Le schéma de la cellule élémentaire est alors équivalent à celui de la figure 3c. L'information I mémorisée peut alors être lue sur le fil de lecture 3.

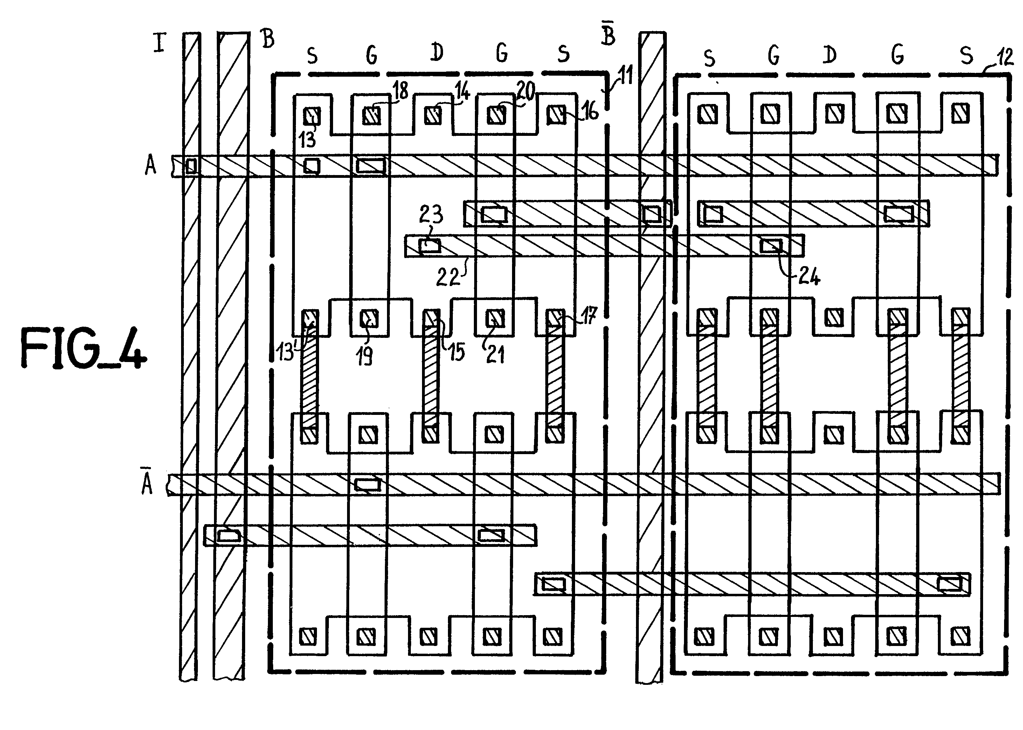

La cellule élémentaire de mémoire vive suivant l'invention, réalisée en circuit intégré prédiffusé, est représentée sur la figure 4.

Un circuit intégré prédiffusé se compose d'un ensemble de transistors disposés suivant des rangées parallèles qui sont alternativement de type N et de type P. Une cellule de base, telle que 11 ou 12, d'un circuit intégré prédiffusé comporte quatre transistors MOS, dont deux transistors de type N et deux transistors de type P occupant deux rangées adjacentes.

Pour faciliter les interconnexions, les électrodes de ces transistors sont accessibles en des points groupés par paires. Ainsi, pour la cellule de base 11, l'une des électrodes de transfert (drain ou source) du transistor de gauche de la rangée supérieure est accessible en des points 13 et 13'. L'autre électrode de transfert de ce transistor, commune avec l'une des électrodes de transfert du transistor de droite est accessible en des points 14 et 15, l'autre électrode de transfert de ce dernier étant accessible en des points 16 et 17. Chacun de ces transistors comporte une grille, ou électrode de commande, accessible en des points 18 et 19 pour le transistor de gauche, et 20 et 21 pour le transistor de droite.

La réalisation d'une cellule élémentaire de mémoire vive suivant l'invention nécessite quatre transistors de type P et quatre transistors de type N (deux par interrupteur, deux par inverseur), soit au total deux cellules de base telles que 11 et 12, et la totalité des transistors de ces cellules est utilisée, ce qui garantit une compacité et un gain de surface maximums.

On a également représenté sur la figure 4 les connexions de raccordement entre les différentes électrodes de ces transistors, permettant de réaliser le schéma logique de la figure 1, la passage d'une figure à l'autre étant facilité par les figures 2a et 2b montrant l'étape intermédiaire de réalisation d'un interrupteur et d'un inverseur à l'aide de transistors MOS.

Sur le schéma de la figure 4, on a symbolisé ces connexions de raccordement par des bandes, horizontales ou verticales, hâchurées. Ainsi la bande horizontale 22 assure une connexion entre la grille du transistor situé en haut à droite de la cellule de base 11, à laquelle elle accède par un trou de connexion 23 (symbolisé par un carré), et la grille du transistor situé en haut à gauche de la cellule de base 12, à laquelle elle accède par un trou de connexion 24 (également symbolisé par un carré). Les fils véhiculant les signaux A, $\bar{A}$, B, $\bar{B}$ et I ont été représentés, comme les connexions de raccordement, par des bandes horizontales ou verticales hâchurées.

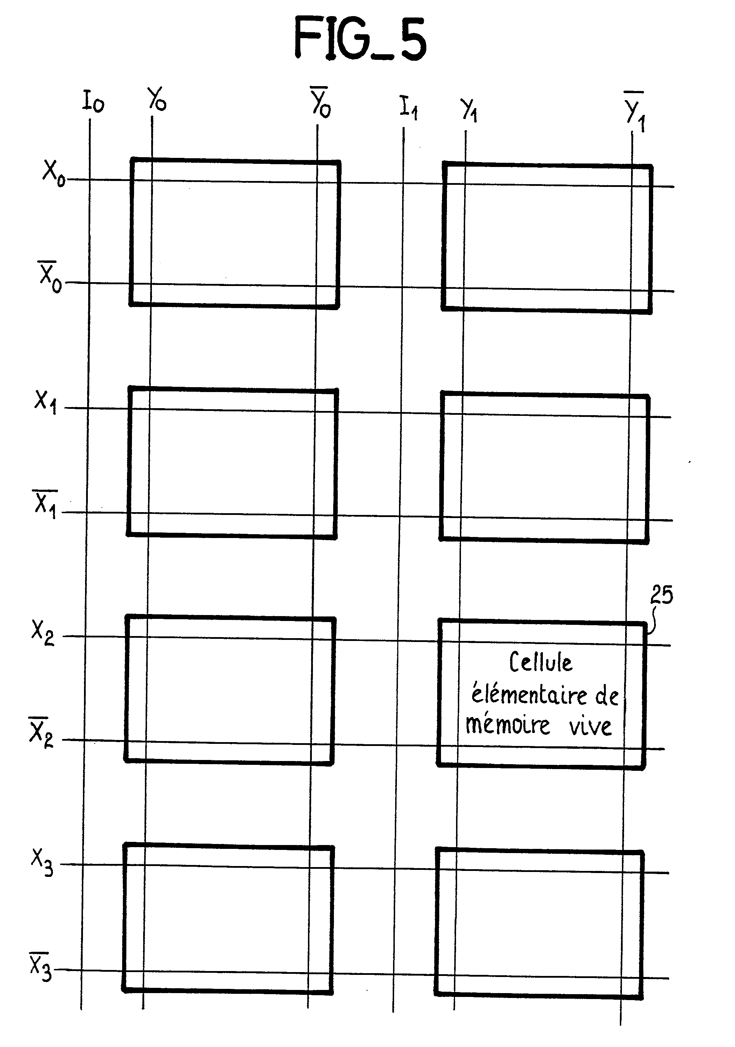

Sur la figure 5 on a représenté un arrangement de huit cellules élémentaires 25 de mémoire vive telles que celle représentée sur la figure 4, disposées suivant une matrice à quatre lignes (numérotées de 0 à 3) et deux colonnes (numérotées de 0 à 1), pour former une mémoire vive à quatre mots de deux bits.

Les cellules disposées sur une même ligne sont commandées par les mêmes signaux X et $\bar{X}$ ($X_2$ et $\bar{X}_2$ pour le cas de la ligne 2 par exemple). Les cellules disposées sur une même colonne sont commandées par les mêmes signaux Y et $\bar{Y}$ ($Y_1$ et $\bar{Y}_1$ pour le cas de la colonne 1 par exemple). L'ensemble des signaux X, $\bar{X}$, Y, $\bar{Y}$ correspond aux signaux A, $\bar{A}$, B, $\bar{B}$ utilisés précédemment pour une seule cellule élémentaire.

Cette commande matricielle assure une commande individuelle distincte pour chacune des cellules. Ainsi la cellule 25 située au croisement de la deuxième ligne et de la première colonne est commandée de manière unique par l'ensemble ($X_2$, $\bar{X}_2$, $Y_2$, $\bar{Y}_2$).

Outre sa commande, chaque cellule dispose d'une entrée-sortie pour les informations I à écrire et à lire. Mais l'adressage étant exclusif par mots, un nombre total d'entrées-sorties égal au nombre de bits par mot suffit. Ainsi, dans le cas précis de la figure 5, deux entrées-sorties $I_0$ et $I_1$ correspondant aux deux bits d'un mot sont prévues.

Cette disposition matricielle a l'avantage de rendre la structure de ces mémoires indépendante de leur format n x p (n mots de p éléments binaires). En effet un accroissement de l'une des valeurs n et p, ou des deux à la fois, à partir du schéma de la figure 5 par exemple, se traduit par une simple extension de cette structure dans l'une des directions X, Y ou dans les deux directions à la fois, sans modification de cette structure de base.

Cette disposition a un autre avantage qui est, comme le montre la figure 5, de limiter le réseau d'interconnexions d'un circuit intégré prédiffusé à des connexions verticales. Ceci revêt une importance particulièrement grande dans le cas de circuits intégrés du type prédiffusés à interconnexions libres, car le gain en surface est alors optimum.

# REVENDICATIONS

1. Cellule élémentaire de mémoire vive, caractérisée en ce qu'elle comporte un premier interrupteur (1) dont l'une des entrées constitue l'entrée-sortie de données de la cellule, et dont l'autre entrée est reliée à une boucle comportant dans l'ordre un premier inverseur (4), un deuxième inverseur (5) et un deuxième interrupteur (6), le premier et le deuxième interrupteurs étant commandés de manière que lors d'une opération d'écriture, le premier soit fermé et le deuxième ouvert, qu'en dehors de toute opération d'écriture ou de lecture, le premier soit ouvert et le deuxième fermé, et que lors d'une opération de lecture, le premier et le deuxième soient fermés.

2. Cellule selon la revendication 1, caractérisée en ce qu'elle est réalisée en circuit intégré du type MOS.

3. Cellule selon la revendication 2, caractérisée en ce que chaque interrupteur est réalisé par l'association en parallèle de deux transistors MOS (7, 8), l'un de type P, l'autre de type N, dont les électrodes de transfert sont reliées deux à deux, et dont les électrodes de commande reçoivent deux signaux complémentaires, A et $\bar{A}$ pour l'un (1) de ces deux interrupteurs, B et $\bar{B}$ pour l'autre (6).

4. Mémoire à N mots de P éléments binaires, obtenue par association de N x P cellules élémentaires suivant la revendication 3, caractérisée en ce que ces cellules élémentaires (25) sont disposées sous forme d'une matrice à N lignes et P colonnes, les transistors MOS constitutifs de l'un (1) des deux interrupteurs des cellules disposées suivant une même ligne n° n étant commandés par les mêmes signaux $X_n$ et $\bar{X}_n$ et les transistors MOS constitutifs de l'autre interrupteur (6) des cellules disposées suivant une même colonne n° p étant commandés par les mêmes signaux $Y_p$ et $\bar{Y}_p$.

FIG_1

FIG_2-a

FIG_2-b

# FIG_3-a

# FIG_3-b

# FIG_3-c

FIG_4

0170777

0170777

# FIG_5

$I_0$  $Y_0$  $\overline{Y_0}$  $I_1$  $Y_1$  $\overline{Y_1}$

$X_0$

$\overline{X_0}$

$X_1$

$\overline{X_1}$

$X_2$

25

Cellule
élémentaire de
mémoire vive

$\overline{X_2}$

$X_3$

$\overline{X_3}$

Office européen des brevets

**RAPPORT DE RECHERCHE EUROPEENNE**

0170777

Numéro de la demande

EP 85 10 4032

## DOCUMENTS CONSIDERES COMME PERTINENTS

| Catégorie | Citation du document avec indication. en cas de besoin. des parties pertinentes | Revendication concernee | CLASSEMENT DE LA DEMANDE (Int Cl 4) |
|---|---|---|---|
| | | | G 11 C   11/24 |
| A | IBM TECHNICAL DISCLOSURE BULLETIN, vol. 13, no. 7, décembre 1970, page 1751, New York, US; F.H. GAENSSLEN et al.: "FET memory cell" * En entier * | 1,2 | |
| | --- | | |
| A | US-A-3 644 907 (WESTINGHOUSE ELECTRIC CORP.) * Colonne 3, ligne 17 - colonne 5, ligne 63; figures 2,3 * | 1,2 | |
| | ----- | | |

| | DOMAINES TECHNIQUES RECHERCHES (Int. Cl.4) |
|---|---|
| | G 11 C   11/24 |

Le présent rapport de recherche a été établi pour toutes les revendications

| Lieu de la recherche | Date d'achèvement de la recherche | |
|---|---|---|
| | | DEGRAEVE Examinateur G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82